# EUROPÄISCHE PATENTSCHRIFT

(11) **EP 0 389 820 B1**
(45) Veröffentlichungstag und Bekanntmachung des Hinweises auf die Patenterteilung: **16.06.1993**
(21) Anmeldenummer: 90104004.8
(22) Anmeldetag: 01.03.1990
(51) Int. Cl.: C23C 14/50, C23C 14/56, H01L 21/00

(54) **Vorrichtung zum Ein- und Ausschleusen eines Werkstücks in eine Vakuumkammer**
Device for transferring a workpiece into and out of a vacuum chamber
Dispositif pour faire entrer ou sortir par une écluse une pièce dans une chambre à vide

(30) Priorität: 30.03.1989 DE 3910244
(43) Veröffentlichungstag der Anmeldung: 03.10.1990
(73) Patentinhaber: LEYBOLD AKTIENGESELLSCHAFT, D-63450 Hanau (DE)
(72) Erfinder: Kempf, Stefan, D-8755 Alzenau (DE)

(56) Entgegenhaltungen:
- EP-A- 0 161 928
- EP-A- 0 235 731
- DE-A- 3 716 498
- DE-A- 3 803 411
- US-A- 3 915 117

## Beschreibung

Die Erfindung betrifft eine Vorrichtung zum Ein- und Ausschleusen eines Werkstücks in eine Vakuumkammer, in der sich ein Transportmittel für die Beförderung des Werkstücks befindet.

In der Vakuumverfahrenstechnik, insbesondere in der Dünnschichttechnik ist das Beschichten von Substraten, beispielsweise von Compactdisks (CD) bekannt. Die Compactdisks sind ein modernes Speichermedium für digitale Informationen. In einem Sputterprozess werden die geprägten Kunststoffscheiben mit beispielsweise einer Aluminiumschicht von weniger als einem zehntausendstel Millimeter überzogen. Die hierzu eingesetzten Sputterbeschichtungsanlagen besitzen in vielen Fällen einen Drehteller für die Beförderung der Substrate.

Über eine Schleuse in einem Sauberraum belädt und entlädt ein Roboter die Anlage. Von der Schleuse aus transportiert der Drehteller den Substratträger mit dem Substrat durch die Vakuumkammer. Das Besputtern erfolgt durch eine Hochleistungszerstäubungskatode, die als Magnetron aufgebaut ist.

Durch die Deutsche Offenlegungsschrift 3716498 ist bereits eine Vorrichtung zum Ein- und Ausschleusen eines im wesentlichen flachen Werkstücks in eine evakuierte Beschichtungskammer und zum Zuführen und Rückführen des Werkstücks in und aus dem Bereich einer Beschichtungsquelle zum Zwecke der Behandlung der Werkstückoberfläche bekannt geworden.

Die Vorrichtung nach dieser Offenlegungsschrift ist gekennzeichnet durch eine im Bereich der Beschichtungskammer angeordnete Beschichtungsvorrichtung mit einem oder mehreren deckelförmigen Werkstückträgern, mit Hilfe derer die Werkstücke in eine eine Öffnung der Beschichtungskammer benachbarte Position bringbar sind, von der aus die Öffnung einerseits vom Werkstückträger und andererseits von einem Hubteller verschließbar ist, der auf einem innerhalb der Beschichtungskammer rotierbar gelagerten Drehteller gehalten und geführt ist, wobei der Werkstückträger von einem sich an der Beschickungsvorrichtung abstützenden Hubzylinder an die Öffnung im Deckel der Beschichtungskammer und der Hubteller von einer an der Bodenplatte befestigten Hubvorrichtung anpressbar ist.

Weiterhin existiert die US-Patentschrift 3915117. Die Kurzfassung (Abstract) dieser Patentschrift lautet in deutscher Übersetzung wie folgt:

Eine Beschichtungsanlage zum Beschichten verschiedener Produkte umfasst ein Gehäuse. Das Gehäuse besteht aus einem festen Teil und einem rotierenden Abdeckungsteil. Beide Teile bilden zusammen eine geschlossene gasdichte Gehäusekammer. Die Gehäusekammer kann evakuiert werden. Eine Vielzahl von Produktträgern werden auf den bewegbaren Teil des Gehäuses getragen. Die Produkthalter sind mit Abstand voneinander angeordnet. Sie sind bewegbar, damit sie in verschiedene Operationsstationen gebracht werden können. Einer dieser Operationsstationen umfasst vorzugsweise eine gasdichte Beschichtungskammer. Diese Kammer ist verbindbar mit der gasdichten Gehäusekammer. Die Operationsstation ist mit getrennten Mitteln zur Evakuierung der Beschichtungskammer versehen. Es sind bewegbare Dichtungsmittel an wenigstens einer Station vorgesehen. Die Dichtungsmittel dienen zur Dichtung der Beschichtungskammer und zu deren Trennung von der Gehäusekammer. In gleicher Weise ist eine Beschickungskammer vorzugsweise in einer separaten Station angebracht. Sie ist separat verbindbar mit der Gehäusekammer. Alternativ kann sie von der Gehäusekammer getrennt werden und getrennt evakuiert werden.

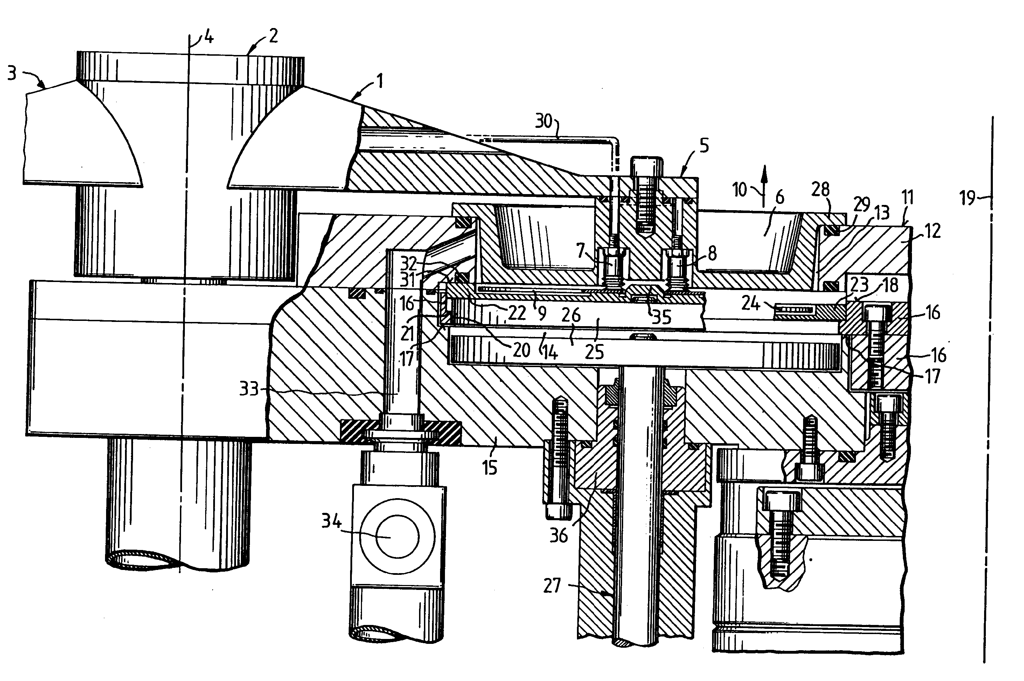

Es existiert weiterhin die europäische Anmeldung EP-A-0161928. Sie befasst sich mit einem System für die Rotation einer Transferplatte eines Beschichtungssystems in einer Vakuumkammer. Im einzelnen wird, siehe hierzu die Figuren 4, 5 und 6 der soeben genannten europäischen Anmeldung, eine Druckplatte 16 gegen die Transferplatte 18 gedrückt. Die Transferplatte ihrerseits wird gegen die Wand 32 gedrückt.

Die Transferplatte der genannten europäischen Anmeldung rotiert um eine horizontal angeordnete Achse. Die Transferplatte des Standes der Technik ist daher vertikal angeordnet.

Demgegenüber, siehe hierzu die nachfolgende Beschreibung, wird beim Gegenstand der Erfindung ein horizontal angeordnetes scheibenförmiges Transportmittel benutzt.

Die Vorrichtungen des Standes der Technik weisen in der Praxis noch folgende weitere Nachteile auf:

Der gesamte Drehteller muß sehr massiv ausgeführt werden. Ebenfalls ist, um Durchbiegungen, siehe dazu der weiter unten folgende Kommentar zur Biegebeanspruchung des Substratträgers, zu vermeiden, eine massive Ausführung des Substratträgers notwendig.

Während der Verfahrenszyklen müssen daher große Massen transportiert werden. Aufgrund der dadurch auftretenden großen Massenträgheitsmomente laufen die Verfahrenszyklen entsprechend langsam ab. Einer ökonomischeren und rationelleren Arbeitsweise sind daher bei den Anlagen des Standes der Technik Grenzen gesetzt.

Der Substrathalter muß deshalb bei Vorrichtungen des Standes der Technik sehr massiv ausgeführt werden, weil beim Hochfahren der Hubvorrichtungen für den Substrathalter und beim Abstützen des Substrathalters an Teilen der Vakuumkammer der Substrathalter selbst hohen Biegebeanspruchungen ausgesetzt ist.

Bei Anlagen des Standes der Technik ist neben der massiven Ausführung von Drehteller und Substrathalter, auch der Aufwand an Einzelteilen sehr hoch. Dieser Aufwand multipliziert sich mit der Anzahl der Substrathalter im Drehteller.

Der Erfindung liegen folgende Aufgaben zugrunde:

Die geschilderten Nachteile des Standes der Technik sollen vermieden werden. Es sollen konstruktive Voraussetzungen geschaffen werden für eine filigrane und leichte Ausführung des Drehtellers und des Substrathalters.

Der Drehteller soll im wesentlichen nur die funktionsnotwendigen Teile für die Aufnahme des Substrathalters umfassen. Es soll nicht mehr notwendig sein, massive Komponenten einzusetzen, um Verbiegungen und andere Deformationen zu vermeiden. Die Massenträgheitsmomente sollen verringert werden. Die Arbeitszyklen sollen schneller ablaufen. Die Verlustzeiten, die durch das Rotieren des Drehtellers entstehen, sollen reduziert werden.

Es soll möglich sein, mehr Substrathalter, als dies beim Stand der Technik der Fall ist, in einem Drehteller unterzubringen.

Außerdem soll es durch die Einführung einer filigranen Bauweise möglich gemacht werden, daß die Abmessungen der Kammer (Kammerdicke, Kammervolumen) erheblich optimiert werden können.

Die gestellten Aufgaben werden erfindungsgemäß dadurch gelöst, daß ein horizontal angeordnetes, scheibenförmiges Transportmittel vorgesehen ist, das mindestens eine durchgehende, vertikale Öffnung aufweist, daß eine separate Haltevorrichtung für ein Werkstück, wobei diese Haltevorrichtung beim Ein- und Ausschleusen eines Werkstücks innerhalb der vertikalen Öffnung in vertikaler Richtung bewegbar und gegen Teile der Vakuumkammer anpressbar ist, wodurch die Vakuumkammer beim Ein- und Ausschleusen abgedichtet ist, vorgesehen ist, daß eine separate Hub- und Stützvorrichtung für die vertikale Bewegung der Haltevorrichtung innerhalb der vertikalen Öffnung und für die Anpressung der Haltevorrichtung gegen Teile der Vakuumkammer vorgesehen ist.

Um eine über den gesamten Querschnitt der Haltevorrichtung wirkende Abstützung zu erzielen, wird vorgeschlagen, daß die Hub- und Stützvorrichtung für die Haltevorrichtung eine axial bewegbare Stützplatte aufweist.

Zur Verringerung der bewegten Massen wird weiterhin vorgesehen, daß die Haltevorrichtung als dünne, insbesondere membranartige Scheibe ausgebildet ist.

Es wird weiterhin vorgeschlagen, daß die Haltevorrichtung mit einer Zentriervorrichtung, insbesondere in Form eines Vorsprungs, für das Werkstück ausgerüstet ist.

Zur Fixierung der Haltevorrichtung auf dem Transportmittel kann vorgesehen werden, daß die vertikale Öffnung einen oder mehrere, insbesondere absatzförmige Anschläge für ein Aufsetzen der Haltevorrichtung aufweist.

Es wird weiterhin vorgeschlagen, daß die Aufnahmeöffnungen in einem drehtellerförmigen Transportmittel angebracht sind.

Eine besonders raumsparende Lösung besteht darin, daß das Transportmittel aus einem Teller besteht, der drehbar in der Vakuumkammer angeordnet ist (Drehteller), der mit mindestens einer kreisrunden Aufnahmeöffnungen versehen ist, die durch die Drehung des Tellers in koaxiale Position zu dem als kreisrunde Stützplatte ausgebildeten Stützelement gebracht wird.

In einem bevorzugten Ausführungsbeispiel wird vorgeschlagen, daß die Haltevorrichtung als Substrathalter, insbesondere für ein diskförmiges Substrat, ausgebildet ist, daß der Drehteller innerhalb der Vakuumkammer, die Teil einer Beschichtungsanlage ist, den Substrathalter mit dem Substrat in den Bereich einer oder mehrerer Beschichtungsquellen, insbesondere Zerstäubungskatoden, bewegt.

Mit der Erfindung werden folgende Vorteile erreicht:

Die gestellten Aufgaben werden gelöst, insbesondere werden die geschilderten Nachteile des Standes der Technik vermieden. Es werden konstruktive Voraussetzungen geschaffen für eine leichte Ausführung des Drehtellers und des Substrathalters. Beide Bauteile sind bis auf ihre funktionswesentlichen Komponenten abgemagert. Aufgrund der stark reduzierten Massenträgheitselemente laufen die Arbeitszyklen schneller ab. Gleichzeitig werden die für das ökonomische Arbeiten der Beschichtungsanlage wichtigen Daten, wie die Abmessungen der Kammer (Kammerdicke, Kammervolumen) wesentlich verbessert.

Weitere Einzelheiten der Erfindung sind der folgenden Beschreibung eines Ausführungsbeispiels der Erfindung zu entnehmen.

Dieses Ausführungsbeispiel wird anhand einer Figur erläutert.

Die Figur zeigt in einem Schnittbild eine Vorrichtung zum Ein- und Ausschleusen einer Disk in eine Vakuumkammer einer Beschichtungsanlage, die mit einer nicht dargestellten Katodenstation ausgerüstet ist.

Bei der nachfolgenden Beschreibung des Ausführungsbeispiels wird von einem Stand der Technik ausgegangen, wie er sich in Form der oben genannten US-Patentschrift 3915117 und der Deutschen Offenlegungsschrift 3716498 darstellt. Die Beschreibung und die Figuren dieses Standes der Technik können daher zur Erläuterung der Ausgangsbasis für das nachfolgend beschriebene Ausführungsbeispiel herangezogen werden.

Mit 1 ist ein Querbalken bezeichnet, der durch das Aggregat 2 heb- und senkbar und drehbar ist. Der Querbalken gehört zu einer Transporteinrichtung, die mit einem Doppelschwenkarm ausgerüstet ist. Der erste Schwenkarm, im vorliegenden Fall der Querbalken 1, ist in der Figur dargestellt. Der zweite Querbalken, der dem ersten Querbalken 1 gegenüberliegend angeordnet ist, ist nur teilweise dargestellt. Er trägt die Bezugsziffer 3.

Der Doppelschwenkarm ist drehbar, und zwar um die Achse 4. Durch Verdrehen wird der erste Querbalken in die Position des zweiten Querbalkens gebracht, während der zweite Querbalken in die Position des ersten Querbalkens gelangt.

Am rechten Ende 5 des Querbalkens ist ein Deckel 6 angeordnet. Im Deckel sind drei Saugvorrichtungen, von denen zwei Saugvorrichtungen 7, 8 in der Figur dargestellt sind, untergebracht, die zum Ansaugen, das heißt Festhalten, eines Substrats dienen. Im vorliegenden Fall besteht das Substrat aus einer Disk 9, von der in der Figur nur der linke Teil dargestellt ist. Wenn der Querbalken durch das Aggregat gehoben wird, hebt er den Deckel 6 in Richtung des Pfeils 10. Nachdem der Deckel oberhalb der Oberkante 11 des Vakuumkammerdeckels 12 gelangt ist, kann der Querbalken um 180 Grad gedreht werden, siehe oben.

Die im Vergleich zur Vakuumkammer kleine Einschleuskammer 13 ist trennbar von der Vakuumkammer 14 der Beschichtungsanlage, wie weiter unten noch im einzelnen beschrieben werden wird. Das Unterteil der Vakuumkammer trägt die Bezugsziffer 15.

In der vorliegenden Figur ist nur der Teil der Vakuumkammer gezeigt, der funktionsmäßig mit der Einschleusstation zusammenwirkt. Die Vakuumkammer ist im vorliegenden Ausführungsbeispiel flach ausgeführt. In ihr ist ein Drehteller 16 untergebracht. Die Bezugsziffer 16 ist mehrfach in der Figur eingetragen, um die Konfiguration des Drehtellers deutlich zu machen. In der Figur ist nur der Teil des Drehtellers gezeigt, der mit der Schleusenstation zusammenwirkt.

Mit 17 ist die Unterkante des Drehtellers bezeichnet. Die Bezugsziffer 17 ist zur Verdeutlichung der Position dieser Unterkante zweifach eingetragen. 18 stellt die Oberkante des Drehtellers dar. Der Drehteller kann innerhalb der Vakuumkammer, die mit 14 bezeichnet ist, um die Achse 19 rotieren.

Der Drehteller kann beispielsweise vier Aufnahmeöffnungen aufweisen, von denen eine in der Figur dargestellt ist und dort die Bezugsziffer 20 trägt. Die Aufnahmeöffnung besteht aus einer zylinderförmigen Ausnehmung im flachen Drehteller 16.

Wegen der gewählten Schnittdarstellung bildet sich die Aufnahmeöffnung als Linie 20 ab. Es handelt sich um die Begrenzungslinie oder die geschnittene Mantelfläche der zylinderförmigen Ausnehmung.

Im Bereich des Randes, beziehungsweise der Mantelfläche 20, der Aufnahmeöffnung im Drehteller 16 ist ein Absatz 21 vorgesehen, auf den sich der Substrathalter 22 setzen kann.

In der Figur rechts ist ein Substrathalter 23 gezeigt und zwar in seiner, auf dem umlaufenden Absatz 21 abgesetzten Position. Links ist der Substrathalter, siehe oben, mit 22 bezeichnet und zwar in seiner angehobenen Position.

Mit 24 ist das Substrat, beziehungsweise die Disk, bezeichnet, die im Substrathalter liegt.

Mit 25, 26 sind zwei Positionen einer Stützplatte gekennzeichnet, wobei 25 die Stützplatte in ihrer oberen Position und 26 die Stützplatte in ihrer unteren Position bezeichnen. Die Stützplatte wird axial bewegt durch eine Hubvorrichtung 27.

36 bezeichnet ein Dichtungs- und Führungsteil. Der Bereich 14 ist, siehe oben, Teil der Vakuumkammer. Er steht also auch während des Be- und Entladens unter Vakuum.

Nachfolgend wird die Verfahrensweise für das Ein- und Ausschleusen eines Werkstücks, hier einer Disk, beschrieben:

In einer Position des Querbalkens 1, die um 180 Grad zu der in der Figur gezeigten Position verschwenkt angeordnet ist, wird durch die Saugvorrichtungen 7, 8 eine Disk aufgenommen, das heißt angesaugt. Der Querbalken 1 und damit der Deckel 6 und die Disk 9 werden angehoben und anschließend um 180 Grad um die Achse 4 verschwenkt. Sie sind dann in einer Position oberhalb derjenigen Position, die in der Figur gezeigt ist.

Anschließend wird der Querbalken mit Deckel und Disk abgesenkt und gelangt in die Position, wie sie in der Figur dargestellt ist. Der Rand 28 des Deckels liegt dichtend auf der Dichtung 29 auf. Es handelt sich hierbei vorzugsweise um einen O-Ring.

Die Saugleitung 30, beziehungsweise Vakuumleitung für die Saugvorrichtungen 7, 8 wird abgeschaltet, so daß der Saugeffekt, beziehungsweise Halteeffekt, fortfällt. Die Disk 9 legt sich in den Substrathalter 22.

Die Stützplatte ist vorher in die Position 25 durch die Hubvorrichtung 27 angehoben worden. Der Substrathalter 22 wird durch die Stützplatte gegen die untere Wand 31 der Vakuumkammer beziehungsweise gegen die Dichtung (O-Ring) 32 gepresst. Die Einsschleuskammer 13 ist nunmehr luftdicht gegenüber der Atmosphäre und gegenüber der Vakuumkammer abgeschlossen.

Die Einschleuskammer wird über die Leitung 33 anschließend evakuiert. Das Schleusenventil 34 ist entsprechend geschaltet.

Nach der Evakuierung der Einschleuskammer 13 fährt die Stützplatte in ihre untere Position,
die mit 26 bezeichnet ist. Die Einschleuskammer 13 wird nunmehr mit der Vakuumkammer 14 verbunden. Der Substrathalter mit der Disk setzt sich auf den Absatz 21 in der Aufnahmeöffnung des Drehtellers 16. In dieser Position ist in der Figur rechts der Substrathalter mit 23 bezeichnet, siehe oben. Das im Substrathalter 23 liegende Substrat trägt in Figur rechts die Bezugsziffer 24.

Der Drehteller kann nun, nach dem Absenken der Stützplatte, zusammen mit dem Substrathalter, der sich unter der Wirkung seines Eigengewichts, wie dargestellt, auf den ringförmigen Absatz 21 des Drehtellers abgesetzt hat und zusammen mit dem im Substrathalter liegenden Substrat, innerhalb der Vakuumkammer rotieren. Das Substrat wird innerhalb der Vakuumkammer zu weiteren Stationen, beispielsweise zu einer Beschichtungsquelle in Form einer Zerstäubungskatode, transportiert.

Es können beispielsweise vier Stationen in der Vakuumkammer angeordnet sein. Der Drehteller würde sich dann im Takt um jeweils 90 Grad drehen. Nach vier Takten wäre ein Arbeitszyklus beendet und das beschichtete Substrat gelangt in die in der Figur mit 24 bezeichnete Position. Es folgt der Ausschleusvorgang.

Die Stützplatte wird bei Beginn des Ausschleusvorgangs aus ihrer Position 26 in die Position 25 gehoben. Damit gelangt das Substrat, beziehungsweise die Disk, aus der Position 23, 24 in die Position 22, 9. Der Substratträger 22 wird durch die Stützplatte 25 gegen die Dichtung 32 gepresst.

Die Einschleuskammer wird dadurch von der Vakuumkammer getrennt. Anschließend wird die Einschleuskammer über die Leitung 33 durch entsprechende Schaltung des Schleusenventils 34 geflutet.

Nachdem die Schleusenkammer geflutet ist, werden durch Öffnen der Saugleitung 30 die Saugvorrichtungen aktiviert, so daß die Saugvorrichtungen die Disk ansaugen und festhalten können.

Anschließend wird der Deckel durch den Querbalken gehoben und danach um 180 Grad geschwenkt. Die beschichtete Disk wird in der nicht dargestellten linken Position von den Saugvorrichtungen freigegeben.

Zusammenfassend kann also gesagt werden, daß in einem Drehteller mehrere dünne membranartige Substratträger angeordnet sind. In der Vertiefung der Substratträger wird das Substrat zentriert abgelegt. Die Zentrierung der Substrate, beziehungsweise Disks, erfolgt durch einen Vorsprung 35 im Zentrum des Substrathalters.

In der Einschleusstation werden die dünnen membranartigen Substratträger von einer Stützplatte gegen eine Dichtung, insbesondere einen O-Ring, gedrückt und bilden so mit dem Vakuumkammerdeckel und dem darüber angeordneten Deckel 28 die Einschleus- oder Ausschleuskammer 13. Der Substrathalter besteht aus einem relativ einfachen Drehteil, vorzugsweise aus Aluminium.

Die Stützplatte 25, 26 ist nur in der Ein- und Ausschleusstation vorgesehen.

Die Stützplatte verhindert das Durchbiegen des dünnen Substrathalters. Auch der Drehteller selbst kann, wie aus der Figur ersichtlich, sehr dünn ausgelegt werden.

Damit werden die Massenträgheitsmomente des Drehtellers und der vier Substrathalter erheblich reduziert.

## Patentansprüche

1. Vorrichtung zum Ein- und Ausschleusen eines Werkstücks in eine Vakuumkammer, in der sich ein Transportmittel für die Beförderung des Werkstücks befindet, dadurch **gekennzeichnet**, daß ein horizontal angeordnetes, scheibenförmiges Transportmittel vorgesehen ist, das mindestens eine durchgehende, vertikale Öffnung aufweist, daß eine separate Haltevorrichtung für ein Werkstück, wobei diese Haltevorrichtung beim Ein- und Ausschleusen eines Werkstücks innerhalb der vertikalen Öffnung in vertikaler Richtung bewegbar und gegen Teile der Vakuumkammer anpressbar ist, wodurch die Vakuumkammer beim Ein- und Ausschleusen abgedichtet ist, vorgesehen ist, daß eine separate Hub- und Stützvorrichtung für die vertikale Bewegung der Haltevorrichtung innerhalb der vertikalen Öffnung und für die Anpressung der Haltevorrichtung gegen Teile der Vakuumkammer vorgesehen ist.

2. Vorrichtung nach Anspruch 1, dadurch **gekennzeichnet**, daß die Hub- und Stützvorrichtung für die Haltevorrichtung eine axial bewegbare Stützplatte (25, 26) aufweist.

3. Vorrichtung nach den Ansprüchen 1 und 2, dadurch **gekennzeichnet,** daß die Haltevorrichtung als dünne, insbesondere membranartige Scheibe (22, 23) ausgebildet ist.

4. Vorrichtung nach einem oder mehreren der vorangegangenen Ansprüche, dadurch **gekennzeichnet**, daß die Haltevorrichtung mit einer Zentriervorrichtung, insbesondere in Form eines Vorsprungs (35), für das Werkstück (9, 24) ausgerüstet ist.

5. Vorrichtung nach einem oder mehreren der vorangegangenen Ansprüche, dadurch **gekennzeichnet**, daß die vertikale Öffnung (Aufnahmeöffnung) (20) einen oder mehrere, insbesondere absatzförmige Anschläge (21) für das Aufsetzen der Haltevorrichtung (22, 23) aufweist.

6. Vorrichtung nach einem oder mehreren der vorangegangenen Ansprüche, dadurch **gekennzeichnet**, daß die vertikalen Öffnungen (Aufnahmeöffnungen) (20) in einem drehtellerförmigen Transportmittel (16) angebracht sind.

7. Vorrichtung nach einem oder mehreren der vorangegangenen Ansprüche, dadurch **gekennzeichnet**, daß das Transportmittel aus einem Teller (16) besteht, der drehbar in der Vakuumkammer angeordnet ist (Drehteller), der mit mindestens einer kreisrunden vertikalen Öffnung (Aufnahmeöffnung) (20) versehen ist, die durch die Drehung des Tellers in koaxiale Position zu dem als kreisrunde Stützplatte (25, 26) ausgebildeten Stützelement gebracht wird.

8. Vorrichtung nach einem oder mehreren der vorangegangenen Ansprüche, dadurch **gekennzeichnet**, daß die Haltevorrichtung als Substrathalter (23, 22), insbesondere für ein diskförmiges Substrat (9, 24), ausgebildet ist, daß der Drehteller (16) innerhalb der Vakuumkammer, die Teil einer Beschichtungsanlage ist, den Substrathalter (23, 22) mit dem Substrat (9, 24) in den Bereich einer oder mehrerer Beschichtungsquellen, insbesondere Zerstäubungskatoden, bewegt.

## Claims

1. Device for the inward and outward transfer of a workpiece into a vacuum chamber in which there is a transport means for conveying the workpiece, characterised in that a horizontally disposed, disc-shaped transport means is provided having at least one vertical through-aperture, in that a separate holding device is provided for a workpiece and, while a workpiece is being transferred inward and outward, this holding device is movable vertically within the vertical aperture and pressable against parts of the vacuum chamber, whereby the vacuum chamber is sealed during inward and outward transfer, in that a separate lifting and support device is provided for the vertical movement of the holding device within the vertical aperture and for pressing the holding device against parts of the vacuum chamber.

2. Device according to claim 1, characterised in that the lifting and support device for the holding device has an axially movable support plate (25, 26).

3. Device according to claims 1 and 2, characterised in that the holding device is formed as a thin, in particular membrane-like disc (22, 23).

4. Device according to one or more of the preceding claims, characterised in that the holding device is equipped with a centring device, in particular in the form of a projection (35), for the workpiece (9, 24).

5. Device according to one or more of the preceding claims, characterised in that the vertical aperture (receiving aperture) (20) has one or more, in particular step-shaped, stops (21) for the mounting of the holding device (22, 23).

6. Device according to one or more of the preceding claims, characterised in that the vertical apertures (receiving apertures) (20) are located in a turntable-type transport means (16).

7. Device according to one or more of the preceding claims, characterised in that the transport means consists of a plate (16), which is mounted rotatably in the vacuum chamber (turntable), and which is provided with at least one circular, vertical aperture (receiving aperture) (20), which is brought by rotation of the plate into a position coaxial with the support element formed as a circular support plate (25, 26).

8. Device according to one or more of the preceding claims, characterised in that the holding device is formed as a substrate support (23, 22), in particular for a disc-shaped substrate (9, 24), and in that, inside the vacuum chamber, which is part of a coating installation, the turntable (16) moves the substrate support (23, 22) with the substrate (9, 24) within range of one or more coating sources, in particular sputtering cathodes.

## Revendications

1. Dispositif de chargement, par écluse, d'une pièce dans une chambre sous vide, et de son déchargement par écluse, chambre dans laquelle se trouve un moyen de transport pour le transport de la pièce, dispositif caractérisé par le fait qu'est prévu un moyen de transport disposé horizontalement, en forme de plateau, qui présente au moins une ouverture verticale continue, par le fait qu'est également prévu un dispositif, distinct, de maintien de la pièce, ce dispositif de maintien pouvant, lors du chargement et du déchargement, par écluse, d'une pièce, se déplacer à l'intérieur de l'ouverture verticale, selon la direction verticale, et se presser contre des parties de la chambre sous vide, ce par quoi la chambre sous vide est rendue étanche lors du chargement et du déchargement par écluse, et par le fait qu'est prévu un dispositif, distinct, de levage et d'appui pour le mouvement vertical du dispositif de maintien à l'intérieur de l'ouverture verticale et pour le pressage du dispositif de maintien contre des parties de la chambre sous vide.

2. Dispositif selon la revendication 1, caractérisé par le fait que le dispositif de levage et d'appui pour le dispositif de maintien présente une plaque d'appui (25, 26) mobile en direction axiale.

3. Dispositif selon les revendications 1 et 2, caractérisé par le fait que le dispositif de maintien est conçu sous forme d'un plateau mince (22, 23), en particulier du type menbrane.

4. Dispositif selon une ou plusieurs des revendications précédentes, caractérisé par le fait que le dispositif de maintien comporte un dispositif de centrage, en particulier sous forme d'une saillie (35) pour la pièce (9, 24).

5. Dispositif selon une ou plusieurs des revendications précédentes, caractérisé par le fait que l'ouverture verticale (ouverture réceptrice) (20) présente une ou plusieurs butées (21), en particulier en forme de gradin , pour que s'y pose le dispositif de maintien (22, 23).

6. Dispositif selon une ou plusieurs des revendications précédentes, caractérisé par le fait que les ouvertures verticales (ouvertures réceptrices) (20) sont rapportées dans un moyen de transport (16) en forme de plateau tournant.

7. Dispositif selon une ou plusieurs des revendications précédentes, caractérisé par le fait que le moyen de transport est constitué d'un plateau (16) qui est disposé dans la chambre sous vide avec liberté de rotation (plateau tournant), qui présente au moins une ouverture verticale circulaire (ouverture réceptrice) (20) qui, par la rotation du plateau, est amenée en position coaxiale à l'élément d'appui conçu sous forme de plaque d'appui circulaire (25, 26).

8. Dispositif selon une ou plusieurs des revendications précédentes, caractérisé par le fait que le dispositif de maintien est conçu sous forme d'un porte-substrat (23, 22), en particulier pour un substrat (9, 24) en forme de disque, qu'à l'intérieur de la chambre sous vide qui fait partie d'une installation de revêtement, le plateau tournant (16) déplace le porte-substrat (23, 22) avec le substrat (9, 24) dans la zone d'une ou plusieurs sources de revêtement, en particulier de cathodes de vaporisation.
